# EUROPEAN PATENT SPECIFICATION

(11) **EP 2 096 767 B1**
(45) Date of publication and mention of the grant of the patent: **09.04.2014**
(21) Application number: 09002847.3
(22) Date of filing: 27.02.2009
(51) Int. Cl.: H04B 1/52, H04B 1/00

(54) **Method and system for processing signals via diplexers embedded in an integrated circuit package**
Verfahren und System zur Signalverarbeitung über in einem integrierten Schaltungspaket eingebetteten Diplexer
Procédé et système de traitement des signaux via des diplexeurs intégrés dans un emballage de circuit intégré

(30) Priority: 29.02.2008 US 40510
(43) Date of publication of application: 02.09.2009
(73) Proprietor: Broadcom Corporation, Irvine, CA 92617 (US)
(72) Inventor: Rofougaran, Ahmadreza, Newport Coast CA 92657 (US)
(74) Representative: Jehle, Volker Armin

(56) References cited:
- DE-A1-102005 037 040
- US-A- 4 210 881
- US-A- 4 240 155
- US-A1- 2003 020 173
- US-A1- 2005 143 023
- US-A1- 2005 205 986

## Description

### FIELD OF THE INVENTION

Certain embodiments of the invention relate to wireless communication. More specifically, certain embodiments of the invention relate to a method and system for processing signals via diplexers embedded in an integrated circuit package.

### BACKGROUND OF THE INVENTION

Mobile communications have changed the way people communicate and mobile phones have been transformed from a luxury item to an essential part of every day life. The use of mobile phones is today dictated by social situations, rather than hampered by location or technology. While voice connections fulfill the basic need to communicate, and mobile voice connections continue to filter even further into the fabric of every day life, the mobile Internet is the next step in the mobile communication revolution. The mobile Internet is poised to become a common source of everyday information, and easy, versatile mobile access to this data will be taken for granted.

As the number of electronic devices enabled for wireline and/or mobile communications continues to increase, significant efforts exist with regard to making such devices more power efficient. For example, a large percentage of communications devices are mobile wireless devices and thus often operate on battery power. Additionally, transmit and/or receive circuitry within such mobile wireless devices often account for a significant portion of the power consumed within these devices. Moreover, in some conventional communication systems, transmitters and/or receivers are often power inefficient in comparison to other blocks of the portable communication devices. Accordingly, these transmitters and/or receivers have a significant impact on battery life for these mobile wireless devices.

Further limitations and disadvantages of conventional and traditional approaches will become apparent to one of skill in the art, through comparison of such systems with the present invention as set forth in the remainder of the present application with reference to the drawings.

US 2005/205986 A1 describes a device comprising one or more active substrates having transistors or diodes formed thereon, one or more passive substrates having inductors, capacitors or resistors formed thereon, a plurality of bonding pads positioned on the active and passive substrates, and bonding wires connected to the bonding pads.

According to the invention, there are provided a method for wireless communication as defined by independent claim 1 and a system for wireless communication as defined by independent claim 6.

Further advantageous features of the invention are defined by the dependent claims.

A system and/or method for processing signals via diplexers embedded in an integrated circuit package, substantially as shown in and/or described in connection with at least one of the figures, as set forth more completely in the claims.
Advantageously, said diplexer comprises one or more hybrid couplers.
Advantageously, said one or more hybrid couplers comprise quarter wavelength transmission lines or any integer multiple of quarter wavelength.
Advantageously, said diplexer is electrically coupled to one or more capacitors in said integrated circuit.
Advantageously, the method further comprises configuring said diplexer via switches in said integrated circuit.
Advantageously, the method further comprises configuring said diplexer via MEMS switches in said multi-layer package.
Advantageously, said diplexers comprise lumped devices.
Advantageously, said lumped devices comprise surface mount devices coupled to said multi-layer package.
Advantageously, said lumped devices comprise devices integrated in said integrated circuit.
Advantageously, said integrated circuit is flip-chip bonded to said multi-layer package.
Advantageously, said diplexer comprises one or more hybrid couplers.
Advantageously, said one or more hybrid couplers comprise quarter wavelength transmission lines or any integer multiple of quarter wavelength.
Advantageously, said diplexer is electrically coupled to one or more capacitors in said integrated circuit.
Advantageously, said diplexer is configured via switches within said integrated circuit.
Advantageously, said diplexer is configured via MEMS switches within said multi-layer package.
Advantageously, said diplexers comprise lumped devices.
Advantageously, said lumped devices comprise surface mount devices coupled to said multi-layer package.
Advantageously, said lumped devices comprise devices integrated in said integrated circuit.
Advantageously, said integrated circuit is flip-chip bonded to said multi-layer package.

Various advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1 is a block diagram of an exemplary wireless system, which may be utilized in accordance with an embodiment of the invention.

FIG. 2A is a block diagram of a 90 degree hybrid diplexer, in accordance with an embodiment of the invention.

FIG. 2B is a block diagram of a transmission line hybrid coupler, in accordance with an embodiment of the invention.

FIG. 2C is a block diagram illustrating a cross-sectional view of a multi-layer package with diplexers, in accordance with an embodiment of the invention.

FIG. 3 is a block diagram illustrating a cross-sectional view of coplanar and microstrip transmission lines, in accordance with an embodiment of the invention.

FIG 4. is a block diagram illustrating exemplary processing of signals via diplexers integrated in a multi-layer package, in accordance with an embodiment of the invention.

### DETAILED DESCRIPTION OF THE INVENTION

Certain aspects of the invention may be found in a method and system for processing signals via diplexers embedded in an integrated circuit package. Exemplary aspects of the invention may comprise generating via a diplexer, one or more RF signals having different frequencies from one or more received RF signals that are received by the diplexer. The diplexer may be integrated in a multi-layer package and the integrated circuit (IC) may be coupled to the multi-layer package. The integrated circuit may be flip-chip bonded to the multi-layer package. The one or more generated RF signals may be processed via one or more circuits within the IC that may be electrically coupled to the multi-layer package. The diplexer may comprise one or more hybrid couplers, which may comprise quarter wavelength transmission lines or any integer multiple of quarter wavelength. The diplexer may be electrically coupled to one or more capacitors that may be within the integrated circuit. The diplexer may be configured via switches in the integrated circuit and/or via MEMS switches that may be within and/or on the multi-layer package. The diplexers may comprise lumped devices, which may comprise surface mount devices coupled to the multi-layer package or devices integrated in the integrated circuit.

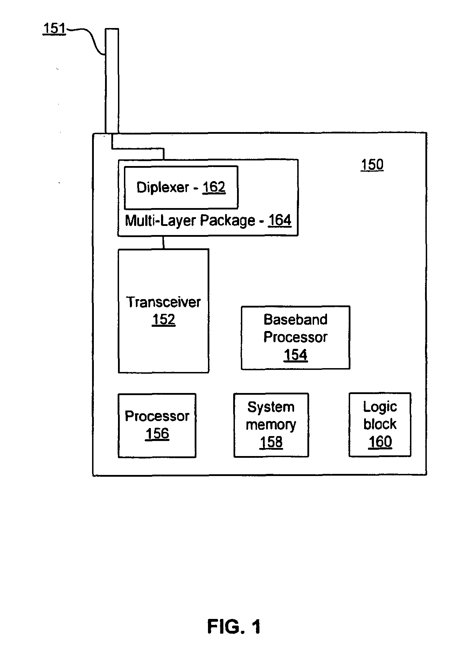

FIG. 1 is a block diagram of an exemplary wireless system, which may be utilized in accordance with an embodiment of the invention. Referring to FIG. 1, the wireless system 150 may comprise an antenna 151, a transceiver 152, a baseband processor 154, a processor 156, a system memory 158, a logic block 160, a diplexer 162, and a multi-layer package 164. The antenna 151 may be used for reception and/or transmission of RF signals.

The transceiver 152 may comprise suitable logic, circuitry, and/or code that may be enabled to modulate and upconvert baseband signals to RF signals for transmission by one or more antennas, which may be represented generically by the antenna 151. The transceiver 152 may also be enabled to downconvert and demodulate received RF signals to baseband signals. The RF signals may be received by one or more antennas, which may be represented generically by the antenna 151. Different wireless systems may use different antennas for transmission and reception. The transceiver 152 may be enabled to execute other functions, for example, filtering, coupling, and/or amplifying the baseband and/or RF signals. Although a single transceiver 152 is shown, the invention is not so limited. Accordingly, the transceiver 152 may be implemented as a separate transmitter and a separate receiver. In addition, there may be a plurality transceivers, transmitters and/or receivers. In this regard, the plurality of transceivers, transmitters and/or receivers may enable the wireless system 150 to handle a plurality of wireless protocols and/or standards including cellular, WLAN and PAN.

The diplexer 162 may comprise suitable circuitry, logic, and/or code that may enable extracting one or more signals of different frequencies from a single RF signal. In another embodiment of the invention, the diplexer 162 may merge one or more RF signals of different frequency into a signal RF signal. The diplexer 162 may be coupled between the transceiver 152 and the antenna 151. The diplexer 162 may be integrated within the multi-layer package 164.

The multi-layer package 164 may comprise multiple layers of insulator and conductive material for integrating multiple devices within the package. The multi-layer package 164 may enable the coupling of multiple devices to an integrated circuit. In an embodiment of the invention, integrated circuits may be flip-chip bonded to the multi-layer package 164. In this manner, devices integrated into the multi-layer package 164 may be coupled to devices within an integrated circuit with low parasitic impedances.

In an embodiment of the invention, the diplexer 162 may be coupled between the transceiver 152 and the antenna 151. The diplexer 162 may be integrated in a multi-layer package comprising metal layers deposited on the top, bottom and/or embedded within the multi-layer package. The diplexer 162 may enable the coupling of one or more RF signals from the transceiver 152 to the antenna 151. In another embodiment of the invention, the diplexer 162 may be enabled to extract one or more signals from a single RF signal received from the antenna 151.

The baseband processor 154 may comprise suitable logic, circuitry, and/or code that may be enabled to process baseband signals for transmission via the transceiver 152 and/or the baseband signals received from the transceiver 152. The processor 156 may be any suitable processor or controller such as a CPU or DSP, or any type of integrated circuit processor. The processor 156 may comprise suitable logic, circuitry, and/or code that may be enabled to control the operations of the transceiver 152 and/or the baseband processor 154. For example, the processor 156 may be utilized to update and/or modify programmable parameters and/or values in a plurality of components, devices, and/or processing elements in the transceiver 152 and/or the baseband processor 154. At least a portion of the programmable parameters may be stored in the system memory 158.

The system memory 158 may comprise suitable logic, circuitry, and/or code that may be enabled to store a plurality of control and/or data information, including parameters needed to calculate frequencies and/or gain, and/or the frequency value and/or gain value. The system memory 158 may store at least a portion of the programmable parameters that may be manipulated by the processor 156.

The logic block 160 may comprise suitable logic, circuitry, and/or code that may enable controlling of various functionalities of the wireless system 150. For example, the logic block 160 may comprise one or more state machines that may generate signals to control the transceiver 152 and/or the baseband processor 154. The logic block 160 may also comprise registers that may hold data for controlling, for example, the transceiver 152 and/or the baseband processor 154. The logic block 160 may also generate and/or store status information that may be read by, for example, the processor 156. Amplifier gains and/or filtering characteristics, for example, may be controlled by the logic block 160.

In operation, control and/or data information, which may comprise the programmable parameters, may be transferred from other portions of the wireless system 150, not shown in FIG. 1, to the processor 156. Similarly, the processor 156 may be enabled to transfer control and/or data information, which may include the programmable parameters, to other portions of the wireless system 150, not shown in FIG. 1, which may be part of the wireless system 150.

The processor 156 may utilize the received control and/or data information, which may comprise the programmable parameters, to determine an operating mode of the transceiver 152. For example, the processor 156 may be utilized to select a specific frequency for a local oscillator, a specific gain for a variable gain amplifier, configure the local oscillator and/or configure the variable gain amplifier for operation in accordance with various embodiments of the invention. Moreover, the specific frequency selected and/or parameters needed to calculate the specific frequency, and/or the specific gain value and/or the parameters, which may be utilized to calculate the specific gain, may be stored in the system memory 158 via the processor 156, for example. The information stored in system memory 158 may be transferred to the transceiver 152 from the system memory 158 via the processor 156.

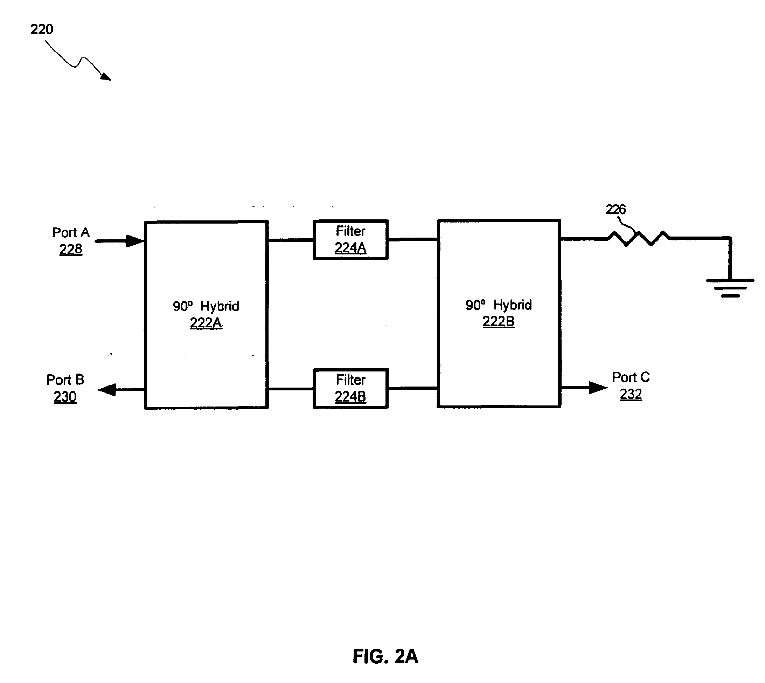

One or more power diplexers may be integrated into an integrated circuit package in the wireless device 150, and may enable the extraction of one or more RF signals from a single RF signal received by the antenna 151. In another embodiment of the invention, the diplexer 162 may multiplex a plurality of RF signals generated by the transceiver 152 into a single RF signal that may be transmitted by the antenna 151. The one or more diplexers may comprise discrete devices and/or one or more 90 degree hybrids, as described further with respect to FIG. 2A. Diplexers may be utilized in balanced amplifiers, high-power transmitters, and/or to transmit via multiple antennas, for example. By integrating diplexers in a package flip-chip bonded to an integrated circuit, parasitic impedances may be significantly reduced, and speed may be increased while reducing losses.

FIG. 2A is a block diagram of a 90 degree hybrid diplexer, in accordance with an embodiment of the invention. Referring to FIG. 2A, there is shown a diplexer 220 comprising 90 degree hybrids 222A and 222B, filters 224A and 224B, and a resistor 226. There is also shown port A 228, port B 230, and port C 232.

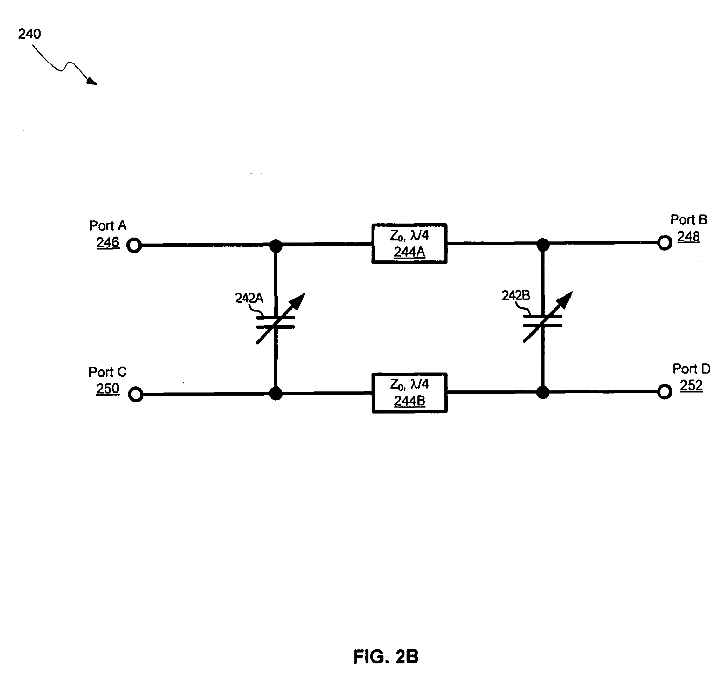

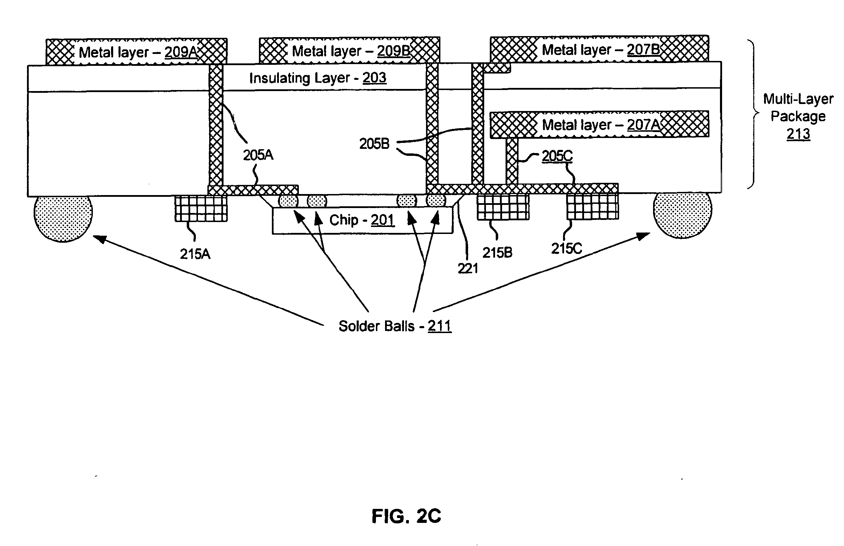

The 90 degree hybrids 222A and 222B may comprise transmission line or lumped element directional couplers that may enable the extraction of signals from an input signal. The resistor 226 may be integrated in an IC package, such as the chip 201, described with respect to FIG. 2C, or may comprise a discrete resistor, such as a surface mount device, also described with respect to FIG. 2C. The 90 degree hybrids 222A and 222B are described further with respect to FIG. 2B.

The filters 224A and 224B may comprise suitable logic, circuitry and/or code that may enable bandpass filtering of signals. The filters 224A and 224B may comprise bandpass filters that may enable passing a signal at a particular frequency while rejecting other frequencies. The filters 224A and 224B may comprise other types of filters, such as notch filters, low-pass, high-pass, or band-stop filters, for example. The filters 224A and 224 may comprise transmission line based filters and/or lumped element filters utilizing discrete inductors, capacitors and resistors.

In operation, an RF signal may be communicated to the port A 226, and two output signals may be generated at the port B 228 and the port C 232, each at a different frequency as defined by the filters 224A and 224B. In this manner, two RF signals of different frequencies may be extracted from a single RF signal. By integrating the diplexer 220 into an integrated circuit package, such as the multi-layer package 164 described with respect to FIG. 1, stray impedances and volume requirements for components may be reduced, while improving performance through reduced losses. Furthermore, frequency response may be more accurate and tunable due to tunable devices in the package and/or integrated circuit, as described with respect to FIGS. 2B and 2C.

FIG. 2B is a block diagram of a transmission line hybrid coupler, in accordance with an embodiment of the invention. Referring to FIG. 2B, there is shown a hybrid coupler 240 comprising quarter wavelength transmission lines 244A and 244B, and variable capacitors 242A and 242B. There is also shown port A 246, port B 248, port C 250, and port D 252.

The quarter wavelength transmission lines 244A and 244B may comprise distributed impedance structures for the propagation of RF signals, and with a length that may equal an odd integer multiple of one fourth of the wavelength of the RF signals to be communicated. The quarter wavelength transmission lines 244A and 244B may comprise a characteristic impedance that may be utilized along with the variable capacitances 242A and 242B to provide impedance matching between devices coupled to the inputs and the outputs of the directional coupler 240. The physical spacing between the quarter wavelength transmission lines 244A and 244B may determine the coupling strength of the directional coupler 240.

The variable capacitors 242A and 242B may comprise capacitors in an integrated circuit, such as an array of CMOS devices, for example. In another embodiment of the invention, the variable capacitors 242A and 242B may comprise one or more discrete capacitors integrated in an IC package that may be switched in or out of the directional coupler 240 via switches. In another embodiment of the invention, the discrete capacitors may be switched by MEMS switches integrated on the IC package, for example. Exemplary embodiments of the invention for integrating devices on an IC package is described further with respect to FIG. 2C.

In operation, an RF signal may be communicated to the port A 246, and the output signal may be communicated to the port B 248. A forward coupled RF signal may be communicated to the port C 250, and a reverse coupled RF signal may be communicated to the port D 252. Directional couplers, such as the directional coupler 240 may be utilized as the 90 degree hybrids 222A and 222B, to enable the extraction of one or more signals from a single input signal.

Alternatively, an input signal may be communicated to the port B 248 and an output signal may then be communicated from the port A 246. In this manner, the forward and reverse coupled signals from the port C 250 and the port D 252 may be utilized to measure the power of the input signal communicated to the port A 246 and/or the port B 248.

Additionally, the directional coupler may provide load and source isolation. The variable capacitors 242A and 242B may be configured to change the directional characteristics of the directional coupler 240 such that signals propagating in opposite directions may have different coupling efficiencies. The impedance configuration may also minimize reflections at the port connections of the directional coupler 240.

In another embodiment of the invention, lumped elements such as resistors, inductors, and capacitors may be utilized as opposed to the quarter wavelength transmission lines 244A and 244B. Lumped elements may be integrated in an integrated circuit or an integrated circuit package, as described further with respect to FIG. 2C.

FIG. 2C is a block diagram illustrating a cross-sectional view of a multi-layer package with diplexers, in accordance with an embodiment of the invention. Referring to FIG. 2C, there is shown a chip 201, an insulating layer 203, metal layers 205A, 205B, 205C, 207A, 207B, 209A, and 209B, solder balls 211, a multi-layer package 213, surface mount components 215A, 215B, and 215C, and thermal epoxy 221.

The chip 201, or integrated circuit, may comprise the transceiver 152 described with respect to FIG. 1, or may also comprise any other integrated circuit within the wireless system 150 that may require directional couplers. The chip 201 may be bump-bonded or flip-chip bonded to the multi-layer package 213 utilizing the solder balls 211. In this manner, wire bonds connecting the chip 201 to the multi-layer package 213 may be eliminated, reducing and/or eliminating uncontrollable stray inductances due to wire bonds. In addition, the thermal conductance out of the chip 201 may be greatly improved utilizing the solder balls 211 and the thermal epoxy 221. The thermal epoxy 221 may be electrically insulating but thermally conductive to allow for thermal energy to be conducted out of the chip 201 to the much larger thermal mass of the multilayer package 213.

The metal layers 205A, 205B, 205C, 207A, 207B, 209A, and 209B may comprise deposited metal layers utilized to delineate power splitters and other devices. The metal layers 207A, 207B, 209A, and 209B may be patterned such that they may comprise transmission lines that may be utilized in power splitters for RF signals transmitted and/or received by the antenna 151 and communicated to and/or from the chip 201. The metal layers 209A and 209B may comprise a coplanar transmission line structure and the metal layers 207A and 207B may comprise a coplanar transmission line structure.

In another embodiment of the invention, one or more of the metal layers may comprise ferromagnetic and/or ferrimagnetic layers utilized to define devices such as transformers, inductors, baluns, isolators, circulators, and gyrators. Accordingly, the metal layers 205A, 205B, 205C, 207A, 207B, 209A, and 209B may comprise one or more inductors that may be utilized to provide inductance for the power splitter 240 for example.

The metal layers 205A, 205B, and 205C may provide electrical contact from the transmission line structures and the surface mount devices 215A, 215B, and 215C to the chip 201 via the solder balls 211. The number of metal layers may not be limited to the number of metal layers 205A, 205B, 205C, 207A, 207B, 209A, and 209B shown in FIG. 2. Accordingly, there may be any number of layers embedded within or on the multi-layer package 213, depending on the number of contacts on the chip 201 coupled to the solder balls 211, and the number of diplexers and other devices fabricated within and/or on the multi-layer package 213.

The solder balls 211 may comprise spherical balls of metal to provide electrical, thermal and physical contact between the chip 201 and the multi-layer package 213. In making the contact with the solder balls 211, the chip may be pressed with enough force to squash the metal spheres somewhat, and may be performed at an elevated temperature to provide suitable electrical resistance and physical bond strength. The thermal epoxy 221 may fill the volume between the solder balls 211 and may provide a high thermal conductance path for heat transfer out of the chip 201. The solder balls 211 may also be utilized to provide electrical, thermal and physical contact between the multi-layer package 213 and a printed circuit board comprising other parts of the wireless system 150, described with respect to FIG. 1.

The surface mount devices 215A, 215B, and 215C may comprise discrete circuit elements such as resistors, capacitors, inductors, and diodes, for example. The surface mount devices 215A, 215B, and 215C may be utilized in diplexers, directional couplers, or filters as described with respect to FIGS. 2A and 2B, and may be soldered to the multi-layer package 213 to provide electrical contact.

In operation, the chip 201 may comprise an RF front end, such as the RF transceiver 152, described with respect to FIG. 1, and may be utilized to transmit and receive RF signals. The chip 201 may be electrically coupled to diplexers or other devices fabricated on and/or within the multi-layer package 213, such as transformers, baluns, transmission lines, inductors, capacitors, microstrip filters, coplanar waveguide filters and surface mount devices, for example. Heat from the chip 201 may be conducted to the multi-layer package via the thermal epoxy 221 and the solder balls 211. In an embodiment of the invention, an array of capacitors in the chip 201 may be used in conjunction with diplexers and other devices in and/or on the multi-layer package 213. Similarly, the resistances, capacitances, and inductances in the diplexers, such as those described with respect to FIGS. 2A and 2B, may be configurable via switches in the chip 201 and/or MEMS switches integrated in the multi-layer package 213. In this manner, power splitter output level may be configured by appropriate impedances in the chip and the multi-layer package 213.

By integrating diplexers and other devices in the multi-layer package 213, stray impedances may be greatly reduced compared to wire-bonded connections to devices on printed circuit boards as in conventional systems. In this manner, volume requirements may be reduced and performance may be improved due to lower losses and accurate control of impedances via switches in the chip 201 or on the multi-layer package 213, for example.

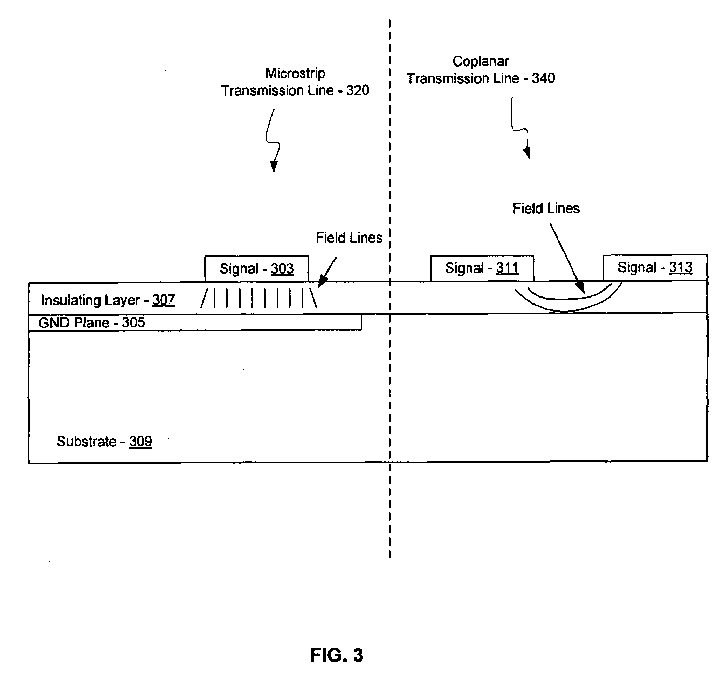

FIG. 3 is a block diagram illustrating a cross-sectional view of coplanar and microstrip transmission lines, in accordance with an embodiment of the invention. Referring to FIG. 3, there is shown a microstrip transmission line 320 and a coplanar transmission line 340, either of which may be used in the 90 degree hybrids 222A and 222B and/or the filters 224A and 224B described with respect to FIG 2A. The microstrip transmission line 320 may comprise signal conductive lines 303, 311, and 313, a ground plane 305, an insulating layer 307 and a substrate 309. The coplanar transmission line 340 may comprise signal conductive lines 311 and 313, the insulating layer 307, and the substrate 309.

The signal conductive lines 303, 311, and 313 may comprise metal traces deposited in and/or on the insulating layer 307. The length of the signal conductive line 303 may correspond to an integer factor of one fourth of the wavelength of the RF signal to be propagated through the microstrip transmission line 320, and the length of the signal conductive lines 311 and 313 may correspond to an integer factor of one fourth of the wavelength of the RF signal to be propagated through the coplanar transmission line 340. In another embodiment of the invention, the signal conductive lines 303, 311, and 313 may comprise poly-silicon or other conductive material. The separation and the voltage potential between the signal conductive line 303 and the ground plane 305 may determine the electric field generated therein. In addition, the dielectric constant of the insulating layer 307 may also determine the electric field between the signal conductive line 303 and the ground plane 305.

The insulating layer 307 may comprise SiO₂ or other insulating material that may provide a high resistance insulating layer between the signal conductive line 303 and the ground plane 305. In addition, the insulating layer 307 may provide a means for configuring the electric field between the signal conductive line 303 and the ground plane 305 by the selection of a material with an appropriate dielectric constant.

The coplanar transmission line 340 may comprise the signal conductive lines 311 and 313 and the insulating layer 307. A signal may be propagated through the coplanar transmission line 340 by applying a signal voltage across the signal conductive lines 311 and 313. The length of the signal conductive lines 311 and 313 may correspond to an integer factor of one fourth of the wavelength of the RF signal to be propagated through the coplanar transmission line 340. The thickness and the dielectric constant of the insulating layer 307 may determine the electric field strength generated by the propagating signal. The characteristic impedance of the coplanar transmission line 340 may be utilized to determine the output power level of a power splitter, such as the power splitter 220 described with respect to FIG. 2A.

The substrate 309 may comprise a semiconductor or insulator material that may provide mechanical support for the microstrip transmission line 320, the coplanar transmission line 340, and other devices that may be integrated. The substrate 309 may comprise the multi-layer package 213, described with respect to FIG. 2C. In another embodiment of the invention, the substrate 309 may comprise Si, GaAs, sapphire, InP, GaO, ZnO, CdTe, CdZnTe and/or Al₂O₃, for example, or any other substrate material that may be suitable for integrating microstrip structures.

In operation, an AC signal may be applied across the signal conductive line 303 and the ground plane 305, and/or the signal conductive lines 311 and 313. The microstrip transmission line 320 and/or the coplanar transmission line 340 may propagate an RF signal that was communicated to the diplexer 220, described with respect to FIG. 2A. The wavelength of the received RF signal may correspond to the length of the signal conductive lines 303, 311, and 313. In this manner, the frequency of one or more signals extracted from a single received RF signal may be determined by configuring the dimensions of the microstrip transmission line 320 and/or the coplanar transmission line 340. In this manner, system cost and size may be reduced by integrating configurable devices in an integrated circuit package, such as the multi-layer package 213.

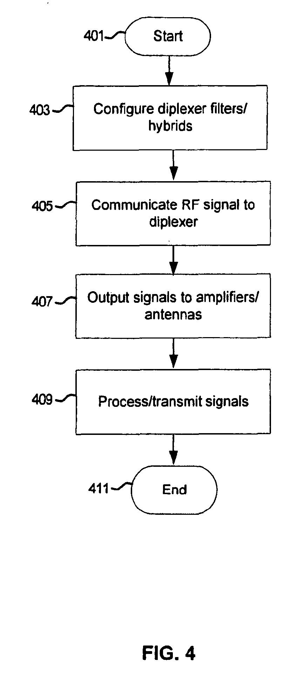

FIG 4. is a block diagram illustrating exemplary processing of signals via diplexers integrated in a multi-layer package, in accordance with an embodiment of the invention. In step 403, after start step 401, one or more filters 224A, 224B and one or more hybrids 222A, 222B in the diplexer 220 may be configured for desired frequencies and may be configured to provide specific output power levels. In step 405, an RF signal may be communicated to the diplexer 220 followed by step 407, where a plurality of output signals may be generated. In step 409, the output RF signals may be processed and/or transmitted, followed by end step 411.

In an embodiment of the invention, a method and system are disclosed for processing signals via diplexers embedded in an integrated circuit package. Exemplary aspects of the invention may comprise generating via a diplexer 220, one or more RF signals at different frequencies from one or more received RF signals. The diplexer 220 may be integrated in a multi-layer package 213. The one or more generated RF signals may be processed via one or more circuits within an integrated circuit 201 that may be electrically coupled to the multi-layer package 213. The diplexer 220 may comprise one or more hybrid couplers 222A, 222B, which may comprise quarter wavelength transmission lines 244A, 244B or any integer multiple of quarter wavelength. The diplexer 220 may be electrically coupled to one or more capacitors in the integrated circuit 201. The diplexer 220 may be configured via switches in the integrated circuit 201 and/or via MEMS switches in the multi-layer package 213. The diplexers 220 may comprise lumped devices, which may comprise surface mount devices 215A, 215B, and 215C coupled to the multi-layer package 213 or devices integrated in the integrated circuit 201. The integrated circuit 201 may be flip-chip bonded to the multi-layer package 213.

Certain embodiments of the invention may comprise a machine-readable storage having stored thereon, a computer program having at least one code section for processing signals via diplexers embedded in an integrated circuit package, the at least one code section being executable by a machine for causing the machine to perform one or more of the steps described herein.

Accordingly, aspects of the invention may be realized in hardware, software, firmware or a combination thereof. The invention may be realized in a centralized fashion in at least one computer system or in a distributed fashion where different elements are spread across several interconnected computer systems. Any kind of computer system or other apparatus adapted for carrying out the methods described herein is suited. A typical combination of hardware, software and firmware may be a general-purpose computer system with a computer program that, when being loaded and executed, controls the computer system such that it carries out the methods described herein.

One embodiment of the present invention may be implemented as a board level product, as a single chip, application specific integrated circuit (ASIC), or with varying levels integrated on a single chip with other portions of the system as separate components. The degree of integration of the system will primarily be determined by speed and cost considerations. Because of the sophisticated nature of modern processors, it is possible to utilize a commercially available processor, which may be implemented external to an ASIC implementation of the present system. Alternatively, if the processor is available as an ASIC core or logic block, then the commercially available processor may be implemented as part of an ASIC device with various functions implemented as firmware.

The present invention may also be embedded in a computer program product, which comprises all the features enabling the implementation of the methods described herein, and which when loaded in a computer system is able to carry out these methods. Computer program in the present context may mean, for example, any expression, in any language, code or notation, of a set of instructions intended to cause a system having an information processing capability to perform a particular function either directly or after either or both of the following: a) conversion to another language, code or notation; b) reproduction in a different material form. However, other meanings of computer program within the understanding of those skilled in the art are also contemplated by the present invention.

While the invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiments disclosed, but that the present invention will include all embodiments falling within the scope of the appended claims.

## Claims

1. A method for wireless communication, the method comprising:
configuring a diplexer (162, 220) via switches by switching one or more capacitors (242) into or out of said diplexer (162, 220);
generating via said diplexer (162, 220), a plurality of RF signals having different frequencies, wherein said plurality of RF signals are generated, at a plurality of output ports (230, 232, 248, 252), from one or more RF signals received by said diplexer (162, 220) at an input port (228, 246, 250), and wherein said diplexer (162, 220) is integrated in a multi-layer package (164, 213); and
processing said plurality of RF signals via one or more circuits within an integrated circuit (201), wherein said integrated circuit (201) is bonded to said multi-layer package (164, 213).

2. The method according to claim 1, wherein said diplexer (162, 220) comprises one or more hybrid couplers (220, 240).

3. The method according to claim 2, wherein said one or more hybrid couplers (220, 240) comprise quarter wavelength transmission lines (244) or any integer multiple of quarter wavelength.

4. The method according to claim 1, wherein said diplexer (162, 220) is electrically coupled to one or more capacitors (242) in said integrated circuit (201).

5. The method according to claim 1, comprising configuring said diplexer (162, 220) via switches in said integrated circuit (201) and/or via MEMS switches within and/or on said multi-layer package (164, 213).

6. A system for wireless communication, the system comprising:
a multilayer package bonded to an integrated circuit (201), wherein said multilayer package (164, 213) comprises a diplexer (162, 220) adapted to be configured via switches by switching one or more capacitors (242) into or out of said diplexer (162, 220);
said diplexer (162, 220) being adapted to generate a plurality of RF signals having different frequencies, wherein said plurality of RF signals are generated, at a plurality of output ports (230, 232, 248, 252), from one or more RF signals received by said diplexer (162, 220) at an input port (228, 246, 250); and
one or more circuits within said integrated circuit (201) that processes said plurality of RF signals.

7. The system according to claim 6, wherein said diplexer (162, 220) comprises one or more hybrid couplers (220, 240).

8. The system according to claim 6, wherein said one or more hybrid couplers (220, 240) comprise quarter wavelength transmission lines (244) or any integer multiple of quarter wavelength.

9. The system according to claim 8, wherein said quarter wavelength transmission lines (244) comprise distributed impedance structures for the propagation of RF signals, and with a length that equals an odd integer multiple of one fourth of the wavelength of the RF signals to be communicated.

10. The system according to claim 6, wherein said the diplexer (162, 220) is adapted to multiplex said plurality of RF signals into a single RF signal.

11. The system according to claim 6, wherein said diplexer (162, 220) comprises lumped devices which are integrated in said integrated circuit (201).

12. The system according to claim 6, wherein said lumped devices comprise surface mount devices (215) coupled to said multi-layer package (164, 213).

13. The system according to claim 6, wherein said integrated circuit (201) is flip-chip bonded to said multi-layer package (164, 213).

14. The system according to claim 6, further comprising a processor (156) and a transceiver (152), said processor (156) being configured to receive control and/or data information including programmable parameters, and to utilize said received control and/or data information to determine an operating mode of said transceiver (152).

15. The system according to claim 6, wherein said processor (156) may be utilized to select a specific frequency for a local oscillator, a specific gain for a variable gain amplifier, configure the local oscillator and/or configure the variable gain amplifier for operation in accordance with various embodiments of the invention.

## Patentansprüche

1. Verfahren zur Drahtloskommunikation, wobei das Verfahren umfasst:
Konfigurieren eines Diplexers (162, 220) über Schalter durch Schalten eines oder mehrerer Kondensatoren (242) in oder aus dem Diplexer (162, 220);
Erzeugen, über den Diplexer (162, 220), einer Vielzahl von HF-Signalen mit verschiedenen Frequenzen, wobei die Vielzahl von HF-Signalen an einer Vielzahl von Ausgangsports (230, 232, 248, 252) aus einem oder mehreren HF-Signalen erzeugen werden, die von dem Diplexer (162, 220) an einem Eingangsport (228, 246, 250) empfangen werden, und wobei der Diplexer (162, 220) in einem Mehrschichtpaket (164, 213) integriert ist; und
Verarbeiten der Vielzahl von HF-Signalen über eine oder mehrere Schaltungen in einer integrierten Schaltung (201), wobei die integrierte Schaltung (201) an das Mehrschichtpaket (164, 213) gebondet ist.

2. Verfahren nach Anspruch 1, wobei der Diplexer (162, 220) einen oder mehrere Hybridkoppler (220, 240) aufweist.

3. Verfahren nach Anspruch 2, wobei der eine oder die mehreren Hybridkoppler (220, 240) Viertelwellenlängen-Sendeleitungen (244) oder ein beliebiges ganzzahliges Vielfaches einer Viertelwellenlänge aufweisen.

4. Verfahren nach Anspruch 1, wobei der Diplexer (162, 220) mit einem oder mehreren Kondensatoren (242) in der integrierten Schaltung (201) elektrisch verbunden ist.

5. Verfahren nach Anspruch 1, das das Konfigurieren des Diplexers (162, 220) über Schalter in der integrierten Schaltung (201) und/oder über MEMS-Schalter in und/oder auf dem Mehrschichtpaket (164, 213) umfasst.

6. System zur Drahtloskommunikation, wobei das System aufweist:
ein Mehrschichtpaket, das an eine integrierte Schaltung (201) gebondet ist, wobei das Mehrschichtpaket (164, 213) einen Diplexer (201) aufweist, der dazu ausgelegt ist, über Schalter durch Schalten eines oder mehrerer Kondensatoren (242) in oder aus dem Diplexer (162, 220) konfiguriert zu werden;
wobei der Diplexer (162, 220) dazu ausgelegt ist, eine Vielzahl von HF-Signalen mit verschiedenen Frequenzen zu erzeugen, wobei die Vielzahl von HF-Signalen an einer Vielzahl von Ausgangsports (230, 232, 248, 252) aus einem oder mehreren HF-Signalen erzeugen werden, die von dem Diplexer (162, 220) an einem Eingangsport (228, 246, 250) empfangen werden; und
eine oder mehrere Schaltungen in der integrierten Schaltung (201), die die Vielzahl von HF-Signalen verarbeiten.

7. System nach Anspruch 6, wobei der Diplexer (162, 220) einen oder mehrere Hybridkoppler (220, 240) aufweist.

8. System nach Anspruch 6, wobei der eine oder die mehreren Hybridkoppler (220, 240) Viertelwellenlängen-Sendeleitungen (244) oder ein beliebiges ganzzahliges Vielfaches einer Viertelwellenlänge aufweisen.

9. System nach Anspruch 8, wobei die Viertelwellenlängen-Sendeleitungen (244) verteilte Impedanzstrukturen für die Verbreitung von HF-Signalen aufweisen, und mit einer Länge, die gleich einem ungeraden ganzzahligen Vielfachen eines Viertels der Wellenlänge der zu kommunizierenden HF-Signale ist.

10. System nach Anspruch 6, wobei der Diplexer (162, 220) dazu ausgelegt ist, die Vielzahl von HF-Signalen in ein einziges HF-Signal zu multiplexen.

11. System nach Anspruch 6, wobei der Diplexer (162, 220) konzentrierte Vorrichtungen aufweist, die in der integrierten Schaltung (201) integriert sind.

12. System nach Anspruch 6, wobei die konzentrierten Vorrichtungen oberflächenmontierte Vorrichtungen (215) aufweisen, die mit dem Mehrschichtpaket (164, 213) gekoppelt sind.

13. System nach Anspruch 6, wobei die integrierte Schaltung (201) ein Flip-Chip ist, der an das Mehrschichtpaket (164, 213) gebondet ist.

14. System nach Anspruch 6, das des Weiteren einen Prozessor (156) und einen Transceiver (152) aufweist, wobei der Prozessor (156) dazu konfiguriert ist, Steuer- und/oder Dateninformationen zu empfangen, die programmierbare Parameter enthalten, und die empfangenen Steuer- und/oder Dateninformationen zu verwenden, um einen Betriebsmodus des Transceivers (152) zu bestimmen.

15. System nach Anspruch 6, wobei der Prozessor (156) verwendet werden kann, um eine spezifische Frequenz für einen lokalen Oszillator auszuwählen, eine spezifische Verstärkung für einen Verstärker mit variabler Verstärkung auszuwählen, den lokalen Oszillator zu konfigurieren und/oder den Verstärker mit variabler Verstärkung zu konfigurieren, zum Betrieb gemäß verschiedenen Ausführungsformen der Erfindung.

## Revendications

1. Procédé de communication sans fil, le procédé comprenant :
la configuration d'un duplexeur (162, 220) par l'intermédiaire de commutateurs en commutant un ou plusieurs condensateur(s) (242) dans ledit ou hors dudit duplexeur (162, 220) ;
la génération, par l'intermédiaire dudit duplexeur (162, 220), d'une pluralité de signaux RF ayant des fréquences différentes, dans lequel ladite pluralité de signaux RF sont générés, au niveau d'une pluralité de ports (230, 232, 248, 252) de sortie, à partir d'un ou plusieurs signaux RF reçus par ledit duplexeur (162, 220) au niveau d'un port (228, 246, 250) d'entrée, et dans lequel ledit duplexeur (162, 220) est intégré dans un ensemble (164, 213) à couches multiples ; et
le traitement de ladite pluralité de signaux RF par l'intermédiaire d'un ou plusieurs circuits au sein d'un circuit intégré (201), dans lequel ledit circuit intégré (201) est lié audit ensemble (164, 213) à couches multiples.

2. Procédé selon la revendication 1, dans lequel ledit duplexeur (162, 220) comprend un ou plusieurs coupleurs (220, 240) hybrides.

3. Procédé selon la revendication 2, dans lequel ledit un ou lesdits plusieurs coupleur(s) (220, 240) hybride(s) comprend/comprennent des lignes de transmission (244) en quart de longueur d'onde ou en un entier quelconque multiple d'un quart de longueur d'onde.

4. Procédé selon la revendication 1, dans lequel ledit duplexeur (162, 220) est électriquement couplé à un ou plusieurs condensateurs (242) dans ledit circuit intégré (201).

5. Procédé selon la revendication 1, comprenant la configuration dudit duplexeur (162, 220) par l'intermédiaire de commutateurs dans ledit circuit intégré (201) et/ou par l'intermédiaire de commutateurs MEMS au sein dudit et/ou sur ledit ensemble (164, 213) à couches multiples.

6. Système de communication sans fil, le système comprenant :
un ensemble à couches multiples lié à un circuit intégré (201), dans lequel ledit ensemble (164, 213) à couches multiples comprend un duplexeur (162, 220) adapté à être configuré par l'intermédiaire de commutateurs en commutant un ou plusieurs condensateurs (242) dans ledit ou hors dudit duplexeur (162, 220) ;
ledit duplexeur (162, 220) étant adapté à générer une pluralité de signaux RF ayant des fréquences différentes, dans lequel ladite pluralité de signaux RF sont générés, au niveau d'une pluralité de ports (230, 232, 248, 252) de sortie, à partir d'un ou plusieurs signaux RF reçus par ledit duplexeur (162, 220) au niveau d'un port (228, 246, 250) d'entrée ; et
un ou plusieurs circuits au sein dudit circuit intégré (201) qui traitent ladite pluralité de signaux RF.

7. Système selon la revendication 6, dans lequel ledit duplexeur (162, 220) comprend un ou plusieurs coupleurs (220, 240) hybrides.

8. Système selon la revendication 6, dans lequel ledit un ou lesdits plusieurs coupleur(s) (220, 240) hybride(s) comprend/comprennent des lignes de transmission (244) en quart de longueur d'onde ou en un entier quelconque multiple d'un quart de longueur d'onde.

9. Système selon la revendication 8, dans lequel lesdites lignes de transmission (244) en quart de longueur d'onde comprennent des structures d'impédance distribuées pour la propagation de signaux RF, et avec une longueur qui est égale à un entier impair multiple d'un quart de la longueur d'onde des signaux RF devant être communiqués.

10. Système selon la revendication 6, dans lequel ledit duplexeur (162, 220) est adapté à multiplexer ladite pluralité de signaux RF en un signal RF unique.

11. Système selon la revendication 6, dans lequel ledit duplexeur (162, 220) comprend des dispositifs localisés qui sont intégrés dans ledit circuit intégré (201).

12. Système selon la revendication 6, dans lequel lesdits dispositifs localisés comprennent des dispositifs (215) pour montage en surface couplés audit ensemble (164, 213) à couches multiples.

13. Système selon la revendication 6, dans lequel ledit circuit intégré (201) est une puce à protubérances liée audit ensemble (164, 213) à couches multiples.

14. Système selon la revendication 6, comprenant en outre un processeur (156) et un émetteur-récepteur (152), ledit processeur (156) étant configuré pour recevoir des informations de contrôle et/ou de données incluant des paramètres programmables, et pour utiliser lesdites informations de contrôle et/ou de données reçues pour déterminer un mode de fonctionnement dudit émetteur-récepteur (152).

15. Système selon la revendication 6, dans lequel ledit processeur (156) peut être utilisé pour sélectionner une fréquence spécifique pour un oscillateur local, un gain spécifique pour un amplificateur à gain variable, configurer l'oscillateur local et/ou configurer l'amplificateur à gain variable pour un fonctionnement conformément à divers modes de réalisation de l'invention.
